# EUROPEAN PATENT APPLICATION

(11) **EP 4 398 310 A1**
(43) Date of publication of application: **10.07.2024**
(21) Application number: 23150548.8
(22) Date of filing: 06.01.2023
(51) Int. Cl.: H01L 29/08, H01L 29/10, H01L 29/66, H01L 29/737, H01L 29/732, H01L 21/8222, H01L 27/082

(54) **A METHOD OF MANUFACTURING A SILICON BIPOLAR JUNCTION TRANSISTOR, AND A BJT**

(71) Applicant: NXP B.V., 5656 AG Eindhoven (NL)
(72) Inventor: JOHN, Jay Paul, 5656AG Eindhoven (NL); KIRCHGESSNER, James Albert, 5656AG Eindhoven (NL); SEBEL, Patrick, 5656AG Eindhoven (NL)
(74) Representative: Hardingham, Christopher Mark

(57) **Abstract**

Disclosed is a method of manufacturing a silicon bipolar junction transistor device, the method comprising a sequence of steps including: depositing a polysilicon layer (130) over at least a device region; depositing a dielectric layer (132) over the polysilicon layer; patterning a photoresist layer (222) and etching a window (240) in the dielectric layer and the polysilicon layer through an opening in the photoresist layer; etching a SiGe layer stack (118) through the window, to expose a silicon layer thereunder; patterning a further photoresist layer (144) to expose at least the window; and doping the silicon layer by ion implantation through the window to form a base region (152). A corresponding BJT device is shown in figure 9.

## Description

### Field

The present disclosure relates to methods of manufacturing silicon bipolar junction transistors (BJTs), and BJTs produced thereby.

### Background

Many semiconductor product designs require the integration of heterojunction bipolar transistors (HBTs) and bipolar junction transistors (BJTs) on the same substrate. Whereas HBTs are commonly designed using combinations of III-V semiconductor materials (such a GaAs/AIGaAs, of GaN/AIGaN), for compatibility with silicon-based BJTs, SiGe-HBTs are most widely used in such integrated products. Several process flows are known in order to achieve the integration of SiGe HBTs with silicon-based BJTs.

Recently there has been increased interest in a SiGe HBT structure architecture known as DPSA-SEG (Double Polysilicon Self-Aligned with Selective Epitaxial Growth). But conventional silicon-based BJT architectures, which are known and use non-selective base SiGe technologies such as for example the QuBiC family of process technologies developed by NXP Semiconductors, are not directly compatible with DPSA-SEG SiGe HBTs. Alternative silicon BJT architectures are therefore of interest, and particularly BJT architectures which are compatible and may be implemented using QuBiC process technology.

### Summary

According to a first aspect of the present disclosure, there is provided a Bipolar Junction Transistor, BJT, comprising: a silicon substrate (110) having a major surface; a base region (512) within the silicon substrate and adjacent the major surface; a doped emitter region (802) within the base region and adjacent the major surface; a layer stack (118) comprising SiGe, overlaying the silicon on the major surface; a polysilicon base layer (130) overlaying the layer stack comprising SiGe, the polysilicon base layer and the layer stack comprising SiGe having a window therethrough; a dielectric material (804, 132), forming a dielectric spacer lining the inside perimeter of the window, and at least partially overlaying an upper surface of the base layer; and a polysilicon emitter contact (806), at least partially filling the window within the liner and at least partially overlying the dielectric liner material on the upper surface of the polysilicon base layer, in electrical contact with the doped emitter region and isolated from the base region by the dielectric spacer; wherein the layer stack comprising SiGe abuts the window and is in direct contact with the dielectric spacer.

In one or more embodiments, the polysilicon base layer is electrically connected to the base region through the layer stack comprising SiGe. In one or more embodiments, the layer stack comprising SiGe comprises a top layer of Si, a bottom layer of Si, and at least one layer of SiGe therebetween.

In one or more embodiments, the window extends into the Silicon substrate.

In one or more embodiments the polysilicon base layer comprises a non-uniformity adjacent the window. In one or more embodiments the non-uniformity comprises polycrystalline silicon having an average crystal size which differs from an average crystal size of the remainder of the polysilicon base layer.

In one or more embodiments the dielectric spacer at least partially overlaying an upper surface of the polysilicon base layer is thicker than the dielectric spacer adjacent the layer stack comprising SiGe. This may occur, for instance, when the dielectric spacer adjacent the layer stack is formed in a separate deposition process, than that at least partially overlaying an upper surface of the polysilicon base layer.

According to a second aspect of the present disclosure, there is provided a semiconductor device comprising: a SiGe Heterojunction Bipolar Transistor; and a BJT as described above.

According to a third aspect of the present disclosure, there is provided a method of manufacturing a silicon bipolar junction transistor device, the method comprising a sequence of steps including: prior (2010) processing steps; depositing (2022) a polysilicon layer over at least a device region; depositing (2023) a dielectric layer over the polysilicon layer; patterning (2024) a photoresist layer and etching (2026) a window in the dielectric layer and the polysilicon layer through an opening in the photoresist layer; patterning (2032) a further photoresist layer to expose at least the window; etching (2034) a layer stack comprising SiGe through the window, to expose a silicon layer thereunder; doping (2036) the silicon layer by ion implantation through the window to form a base region; and subsequent (2042) processing steps. By etching the layer stack comprising SiGe at a relatively late stage of the process, and in particular only after the emitter window has been defined, the method may be directly compatible with a relatively wide range of SiGe HBT process flows. Furthermore, it may require a relatively low number of photolithography stages in comparison with some conventional BJT architectures, particularly for those integrable with or integrated into SiGe HBT fabrication. In particular, since the SiGe oxide layer is etched during a relatively late stage of the process flow, this may be combined with other process steps and may avoid the need for a dedicated photolithography stage, which might otherwise be required. Furthermore, this etching process is not directly linked to the etching of the window through the nitride and polysilicon base ("emitter window" etch). When implemented with simultaneous emitter window etch for an HBT device, conventionally the process control is particularly challenging because it is etching layers in both devices. This may be avoided using embodiments of the present disclosure, which may enable a shorter and/or more optimised etch, thereby improving the control.

In one or more embodiments the method further comprises, between the steps of patterning a photoresist layer and etching a window in the electric layer and the polysilicon layer through an opening in the photoresist layer, and etching the layer stack comprising SiGe through the window, to expose a silicon layer thereunder, the step of: etching through a patterned oxide layer over the SiGe layer stack. In some process flows, a patterned oxide layer may be provided, to protect a previously deposited layer stack comprising SiGe during the step of etching the window though the nitride and polysilicon base. Embodiments of the present disclosure may thus remove this patterned oxide prior to etching the SiGe layer stack. In other process flows, the layer stack comprising SiGe may be deposited after etching the nitride and polysilicon base layer, such that no patterned oxide is required.

In one or more embodiments the subsequent processing steps includes overdoping a part of the base region to form an emitter region.

In one or more embodiments, the prior processing steps includes: depositing a layer of oxide over at least the device region; and further comprises, after etching (2026) a window in the dielectric layer and the polysilicon layer through an opening in the photoresist layer: etching (2028) through a thereby exposed region of the oxide to form a cavity, and depositing a SiGe layer stack to fill the cavity. In one or more embodiments the cavity comprises an undercut region below the polysilicon layer.

In one or more embodiments the oxide comprises Tetra-Ethyl Ortho-Silicate, TEOS, oxide. In one or more embodiments the layer stack comprising SiGe, comprises a Si/SiGe/Si stack.

In one or more embodiments etching a window in the dielectric layer and the polysilicon layer through an opening in the photoresist layer is performed using an anisotropic etching process. In one or more such embodiments the anisotropic etching process is a reactive ion etching (RIE) process. The term RIE as used herein is to be interpreted widely, so as to include various types of RIE, such as without limitation reactive ion beam etching (RIBE) and other forms of plasma etching.

In one or more embodiments etching a layer stack comprising SiGe through the window is performed using an isotropic etching process. Typically wet etch processes, using an acidic etchant, are used for such isotropic etching.

In one or more embodiments the subsequent processing steps includes: depositing a dielectric layer on the perimeter of the window, to form a spacer between a subsequently deposited polysilicon emitter contact region and the layer stack comprising SiGe. The spacer layer electrically isolates the SiGe stack from a subsequently deposited polysilicon emitter contact region in the window.

In one or more embodiments, the method includes, after the step of etching (2026) a window in the dielectric layer and the polysilicon layer through an opening in the photoresist layer, depositing a further dielectric layer and etching an opening in the further dielectric layer on a bottom of the window.

These and other aspects of the invention will be apparent from, and elucidated with reference to, the embodiments described hereinafter.

### Brief description of Drawings

Embodiments will be described, by way of example only, with reference to the drawings, in which
FIG. 1A shows a flow chart of processing steps associated with conventional BJT processing;
FIG. 1B shows a flow chart of processing steps associated with BJT processing according to one or more embodiments of the present disclosure;
FIG. 2 shows, schematically, a part-processed, conventional BJT structure after various stages of the processing;
FIG. 3 shows, schematically, a part-processed BJT structure according to one or more embodiments of the present disclosure, after various stages of the processing;
FIG. 4 shows, schematically, a part-processed BJT structure having processing steps associated with manufacture alongside a DSPA-SEG SiGe HBT structure;
FIG. 5 shows a part-processed BJT structure, according to one or more embodiments of the present disclosure, after corresponding processing steps shown in FIG. 4;
FIG. 6 shows, schematically, a part-processed BJT structure having processing steps associated with a conventional (that is to say, not a DSPA-SEG), SiGe HBT structure;
FIG. 7 shows a part-processed BJT structure, according to one or more embodiments of the present disclosure, after corresponding processing steps shown in FIG. 6;
FIG. 8 shows, schematically, a cross-section through a conventional BJT device; and
FIG. 9 shows, schematically, a cross-section through a BJT device according to one or more embodiments of the present disclosure.

It should be noted that the figures are diagrammatic and not drawn to scale. Relative dimensions and proportions of parts of these figures have been shown exaggerated or reduced in size, for the sake of clarity and convenience in the drawings. The same reference signs are generally used to refer to corresponding or similar features in modified and different embodiments

### Detailed description of embodiments

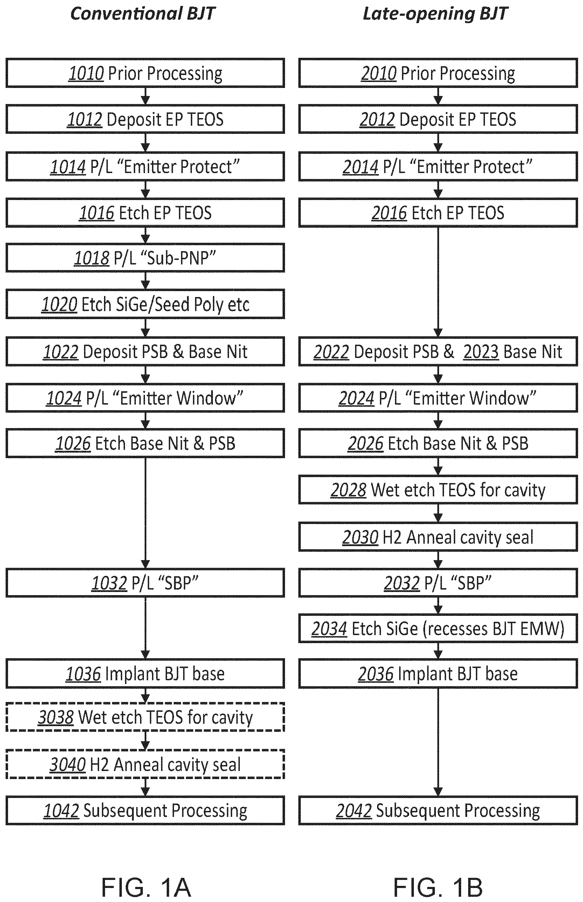

FIG.1A and FIG. 1B, show, side-by-side, processing steps associated with conventional BJT processing, and BJT processing according to one or more embodiments of the present disclosure. For ease of reference, and without any limitation being implied thereby, the process flow according to embodiments of the present disclosure will be referred to hereinunder as "late opening BJT" for reasons which will become more apparent to the skilled person hereinafter. Moreover, the skilled person will appreciate that many additional process steps are involved in the fabrication of the final devices, both prior to those described, and subsequent to those described. Thus FIG.1A, for the conventional process BJT, starts with a first stage 1010 of prior processing steps, and FIG.1B for a late opening BJT, starts with a first stage 2010 of prior processing steps. Prior processing steps may include, but are not limited to, forming various doped regions in the silicon substrate isolated by deep and /or shallow trench isolation (DTI/STI) regions, etc. The prior processing may include deposition of a SiGe layer stack, although in some processes this may not be required, formation of the Deep Trench Isolation (or Shallow Trench Isolation) regions mentioned above, formation of n+ doped buried layers for use as sub-collectors, covered with lower doped collector epi, MOSFET gate poly patterning and implantations, and other process steps, such as will be familiar to the skilled person.

The next step, common to both conventional processing BJT (at step 1012) and late opening BJT (2012), comprises deposition of an emitter protect oxide, such as TEOS oxide (that is to say, silicon oxide which has been deposited from a Tetra-Ethyl Ortho-Silicate precursor). This layer may be referred to as EP TEOS, since it will be used as an Emitter Protection layer in order to shield or protect the emitter region of the device, during later stages of processing.

Thereafter, in another step which is common to both conventional processing BJT (at step 1014) and late opening BJT (at step 2014), an "Emitter Protect" photolithography stage is undertaken by depositing photoresist ("EP photoresist) and patterning it to mask regions of the device, in particular the region of the device which will eventually form the emitter.

Thereafter, in another step which is common to both conventional processing BJT (at step 1016) and late opening BJT (at step 2016), the EP TEOS is removed, by etching, from the regions of the device which are not masked by the EP photoresist.

Thereafter, at step 1018, a further photolithography stage, which may be referred to as a sub-PNP photolithography, is completed in the conventional BJT process flow. This photolithography stage comprises patterning a photoresist layer to expose the SiGe layer stack over the region which will become, in the finished device, most of the, or the entire, BJT device. Thereafter, at step 1020 in the conventional BJT process flow the SiGe layer stack is etched to remove it in the window in the photolithography photoresist. The person skilled in the art of SiGe HBT manufacture will be aware that, prior to depositing SiGe layers in the SiGe layer stack, a polysilicon layer may be deposited.

It will be appreciated that, according to the process flow for the "late opening" BJT according to embodiments of the present disclosure, depicted in FIG. 1B, process steps corresponding to 1018 and 1020 are omitted. As a result, the process flow for the "late opening" BJT device does not, at this stage, open a window through the SiGe layer stack (where one is present).

Thereafter is a process step common to both the conventional BJT process flow (at 1022) and the late opening BJT process flow (at 2022 and 2023). This process step comprises deposition (2022) of a polysilicon base layer ("PSB"), and (2023) a nitride layer, over the entirety of the device. The nitride layer may conveniently be described as a "base-nitride" layer, as it covers the base region.

Thereafter is a photolithography stage, common to both the conventional BJT process flow (at 1024) and the late opening BJT process flow (at 2024), and to the SiGe HBT process, as will be evident hereinunder. This photolithography stage comprises deposition of a photoresist layer and opening a window in the photoresist layer above the area which will become the emitter region of the eventual BJT device. This window may therefore be described as an "emitter window". This is followed by etching of the base nitride and the PSB layer, through the emitter window. These etching steps are common to both the conventional BJT process flow (at 1026) and the late opening BJT process flow (at 2026).

Thereafter are two process steps which are specific to the late opening BJT process flow, and do not occur - at this stage of the process - in the conventional BJT process flow. The first of these process steps is, at 2028, etching through the TEOS which is exposed in the opening through the base nitride and polysilicon base layers, that is to say, in the emitter window. This etching is typically carried out by wet etching which is isotropic or nearly isotropic. As a result, the etching undercuts the polysilicon base layer to some extent, resulting in a partial void or cavity. This void or cavity in the polysilicon base layer is subsequently filled in by a hydrogen-atmosphere annealing stage, at 2030. Silicon from the polysilicon base layer migrates into the cavity during the hydrogen-atmosphere annealing. This may be referred to as sealing the cavity.

Thereafter is a process step common to both the conventional BJT process flow (at 1032) and the late opening BJT process flow (at 2032). This process step comprises a photolithography stage which may be referred to as "Emitter window oversize" photolithography, or silicon bipolar (SBP) photolithography",. It provides a patterned photoresist layer which includes a window over at least the emitter region of the device. In practice, this window is wider than just the hole through the base nitride and polysilicon base, to allow for process tolerances and in particular alignment errors.

In the late opening BJT process flow, the SiGe layer stack is etched through these windows, at step 2034. It will be appreciated that, in the conventional BJT process flow, there is no SiGe layer stack in this region at this stage of the process flow, since it was already removed at step 1020. There is thus no corresponding process step 1034 in the conventional BJT process flow. Since the opening through the SiGe layer stack is provided later in the process, for process flows according to one or more embodiments, the process flow may be described as "late opening" BJT process flow.

Thereafter is a process step common to both the conventional BJT process flow (at 1036) and the late opening BJT process flow (at 2036). This comprises doping the base region of the BJT by implantation through the openings in the photoresist layer, base nitride, polysilicon base, TEOS and SiGe layer stack.

In order for the conventional BJT process flow to be compatible with, and used simultaneously with, SiGe HBT manufacture on the same substrate, two additional process steps are required. Note that these do not directly contribute to the fabrication of the BJT device. The first of these steps is shown in Fig 1A at 3038 and comprises etching through TEOS (which is exposed in the SiGe HBT emitter window). Similarly to process step 2028 in the late opening process flow, this etching is typically carried out by wet etching which is isotropic or nearly isotropic. As a result, the etching undercuts the polysilicon base layer (of the co-fabricated SiGe HBT) to some extent, resulting in a partial void or cavity which is subsequently filled in, during the second of the additional process steps, by a hydrogen-atmosphere annealing stage, as indicated at 3040.

Thereafter follow subsequent process steps common to both the conventional BJT process flow (at 1042) and the late opening BJT process flow (at 2042). These processes will be familiar to the skilled person and include, for example and without limitation, providing a liner to the emitter window by deposition of dielectric material, deposition of highly-doped Si layer to enable contact to the emitter region, (which is isolated from the polysilicon base 130 by the dielectric), deposition and patterning of metal layers to enable the finished device to be contacted, etc.

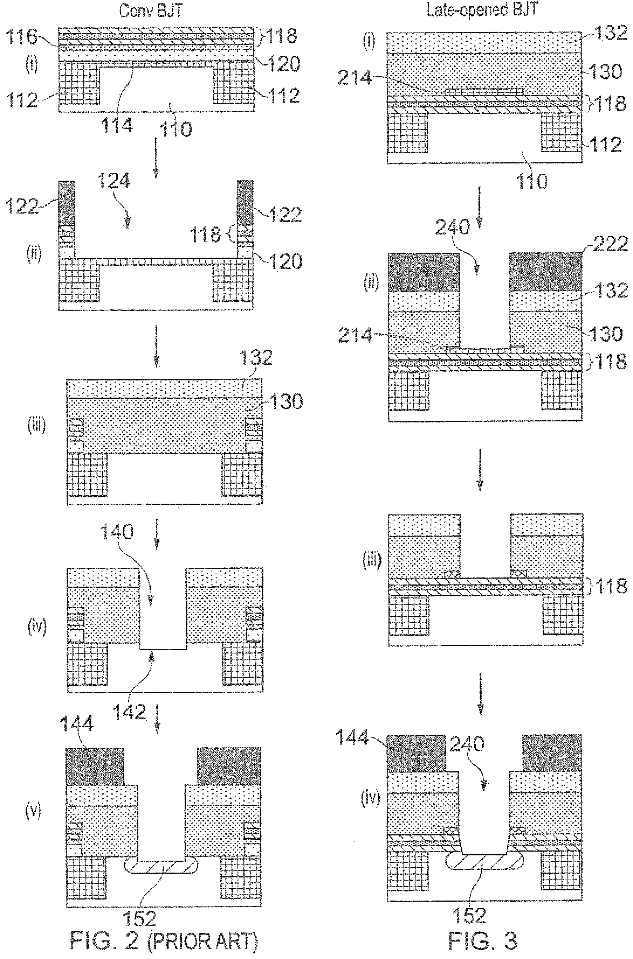

FIG. 2 shows, schematically, a part-processed, conventional BJT structure after various stages of the processing. The BJT structure is integrable, in the same device or integrated circuit (IC), with Silicon-Germanium (SiGe) HBT structures, and may be manufactured through the same process flows.

At (i) is shown a part-processed BJT device. The device typically comprises a lightly doped p-type silicon substrate 110, on which typically is grown an epitaxial, lightly doped n-type layer to form a "collector" layer (not shown), and which includes regions 112 and 114. The region 114 is a "pad oxide" and will be removed from most of the device area prior to the completion of the processing, and in particular prior to deposition of a "base" polysilicon layer, whereas the oxide regions 112 provide deep trench isolation (DTI) or shallow trench isolation (STI) between structures. The skilled person will appreciate that the DTI region is not mandatory, and other forms of isolation may be used. On the silicon substrate 110 is a deposited layer 116 of "base definition nitride" or BD nitride, on which is a SiGe layer stack 118 comprising one or a plurality of layers of SiGe and/or Si (such as a stack: Si/SiGe/Si), optionally with a layer of polysilicon, also referred to as a "seed poly layer" 120, therebetween. It will be noted that as used herein, the term "SiGe layer stack" is to be interpreted as a layer stack which comprises at least one layer of SiGe, rather than a layer stack all layers of which are SiGe Thus the terms "SiGe layer stack" and "layer stack comprising SiGe" are interchangeable herein. It will be appreciated that the SiGe stack layer 118 is required for the fabrication of the HBT devices in the same process flow, but is not required for the BJT device. Thus, in a conventional process flow, the SiGe layer stack 118 is removed from the area which in which the BJT will be formed by being etched, along with the underlying seed polysilicon layer 120 and BD nitride layer 116. This is achieved, as shown at (ii), by a photolithography stage to deposit a photoresist layer 122 in the areas where the SiGe layer stack and BD nitride are to be retained, and etching the stack, any seed layer 120, the BD nitride and the pad oxide 114.

As shown at (iii), a polysilicon layer 130 is deposited over the silicon substrate. The polysilicon layer 130 may be either in-situ p+ doped, that is to say, it is doped as it is deposited, or subsequently doped p+ by means of, for instance, diffusion or ion implantation. On top of the polysilicon layer 130, a dielectric layer 132 is deposited over the silicon substrate. The dielectric layer may comprise, for example, an LPCVD (low-pressure chemical vapour deposition) silicon (di)oxide, or silicon (di)oxide deposited by other means, or silicon nitride. Alternatively, it may comprise a combination of these materials or a stack of these materials.

As shown at (iv), in a subsequent stage of processing, an opening 140 is formed in the dielectric 132 and polysilicon layer 130, in the region in which the BJT is to be formed. This opening may be formed typically by a photolithography stage and selective masking of the layers. The exposed (unmasked) region of the layers is subsequently etched typically by an anisotropic etch such as Reactive Ion Etching (RIE). Use of an anisotropic etch may assist in maintaining dimensions of the device, some of which may be critical to correct device operation characteristics. The opening may be referred to as an emitter window, and the etching exposes the silicon substrate in the area in which the BJT is to be formed. As already mentioned above, the BJT process flow is intended to be compatible with an HBT structure on the same substrate and as part of the same device. The corresponding etch step in the HBT structure, which occurs simultaneously, forms a corresponding opening and includes etching to the exposed TEOS oxide, which acts as an "etch stop", as will be more evident hereinunder. As a result, the etching in the BJT structure typically results in an "over-etch", that is to say part of the silicon substrate is removed, as can be seen at 142, since in this structure, there is no oxide present to act as an etch stop.

As shown at (v), in a subsequent stage of processing, a patterned photoresist layer 144 is defined by a photolithography stage, which may be referred to as "silicon bipolar" (SBP) photolithography. The exposed silicon in the emitter window 140 is subsequently doped p-type, typically by ion implantation, to form a p-type layer 152. This p-type layer 152 forms the base region of the BJT transistor following subsequent process steps (not shown).

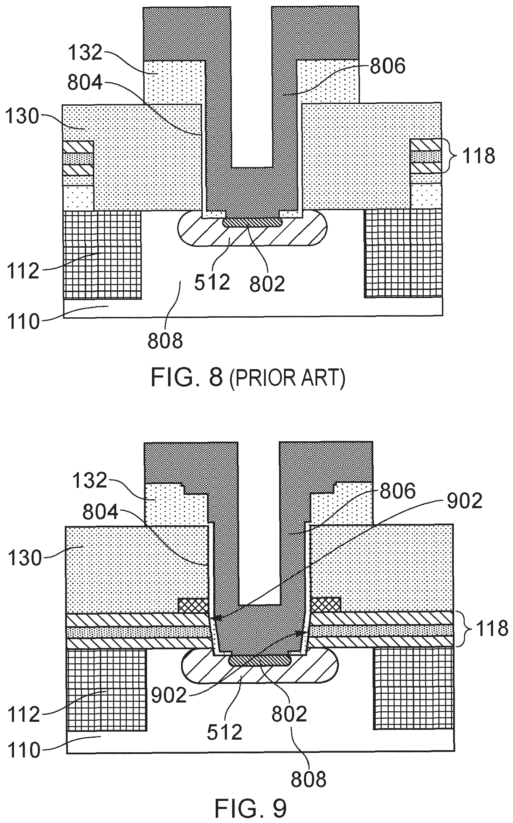

Subsequent to the processing stage depicted at (v), are included steps primarily for the HBT structure - these typically include wet etching the EP TEOS to form a cavity; an H2 annealing stage to "seal" cavity by migration of silicon as discussed above; a link anneal, and deposition of a dielectric spacer layer such as an ONO spacer (which, for the BJT device, isolates the polysilicon base (PSB) 130 from a polysilicon emitter contact region which is subsequently deposited in the window, and can be seen at 806 in FIG. 8).

The above process flow is compatible with conventional SiGe HBT fabrication processes. However, as will become more apparent hereinunder, it is not directly compatible with the recently developed process flows for fabricating double polysilicon self-aligned with selective epitaxial growth (DPSA-SEG) HBTs, such as are being considered for future applications.

FIG. 3 shows, schematically, processing steps involved in the fabrication of a new BJT architecture, according to one or more embodiments of the present disclosure, and integrable in the same device or integrated circuit (IC), with DSPA-SEG SiGe HBT structures. It should be noted that this figure depicts a smaller area than the corresponding images of FIG. 2. Thus, none of the poly layer 120, BD nitride layer 116, and pad oxide layer 114 are visible in FIG. 3, as they have been removed from this region of the device, during prior process steps.

At (i) is shown a part-processed silicon BJT having an architecture according to one or more embodiments. The device includes a silicon substrate 110, having regions 112 therein which comprise a deep and/or shallow trench isolation (DTI/STI) which surrounds and isolates the region of the substrate in and on which the BJT will eventually be formed. On the silicon substrate is shown the SiGe layer stack 118. On top of the SiGe layer stack 118 is a patterned oxide layer 214 such as, but not limited to, TEOS, forming an "EP TEOS", or "emitter protect (EP) oxide". On top of the SiGe layer stack 118 and patterned EP oxide 214 is the deposited polysilicon base (PSB) 130 and the dielectric layer 132 (similar to that shown in stage (iii) of FIG. 2).

At (ii) is shown the part-processed device at a subsequent stage of the processing, in which a photolithography stage to define a patterned photoresist layer 222 has been performed, along with subsequent etching, typically by anisotropic RIE, of the dielectric 132 and polysilicon base 130 to provide an opening 240 in the EP oxide 214. As is apparent from the FIG., the etch stops at the EP oxide layer 214. Thus, according to embodiments of the present disclosure, the emitter protection TEOS functions as a etch stop layer, during the initial stage of definition of the window through the polysilicon base layer to define the BJT.

At (iii) is shown the part-processed device at a subsequent stage of the processing, in which the EP oxide layer 214 previously used as an etch stop has been removed, typically by wet etching. This exposes the SiGe layer stack 118 through the opening. The wet etch processing, being isotropic, or generally or nearly so, exposes an undercut region of the EP oxide. This undercut region is subsequently filled in or "sealed" by a subsequent processing stage comprising a hydrogen-based anneal. In this H2 anneal processing step silicon migrates from the polysilicon base layer in order to fill in or seal the undercut cavity.

At (iv) is shown the part-processed device at a subsequent stage of the processing, which corresponds to processing stage (v) discussed above with reference to FIG. 2 and conventional silicon BJT fabrication process flows. That is to say, a patterned photoresist layer 144 is defined by a photolithography stage, which may be referred to as "BJT emitter window oversize mask" photolithography. The SiGe layer stack now exposed at the bottom of the opening 240 is removed by etching. The exposed silicon in the emitter window 140 is subsequently doped p-type, typically by ion implantation, to form a p-type layer 152.

The fabrication of the device thereafter follows conventional processing steps.

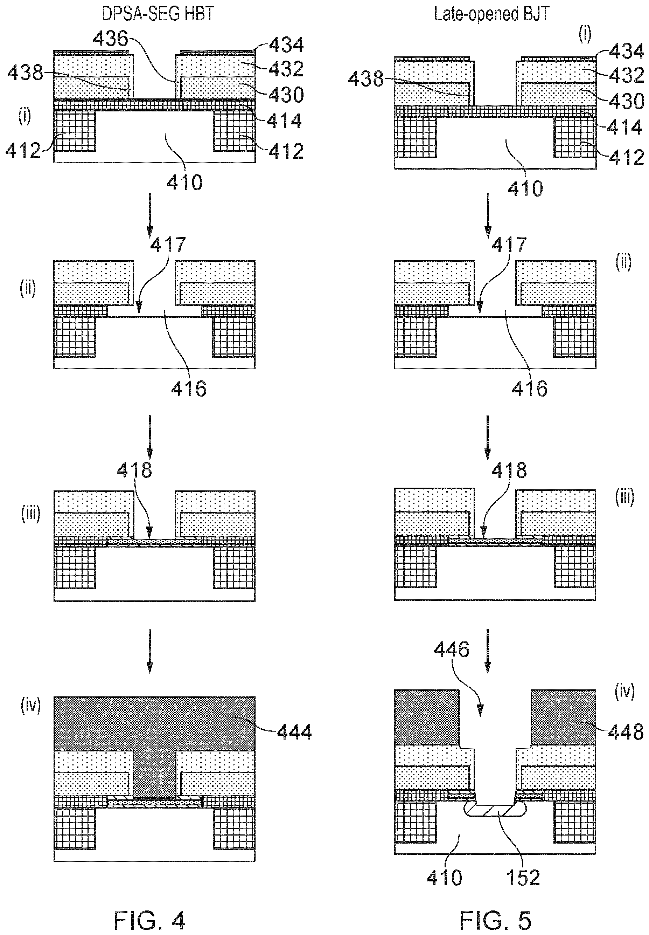

The BJT architecture and fabrication processing steps according to embodiments of the present disclosure may, unlike conventional BJT architecture and fabrication processing steps, be directly compatible with a wide range of SiGe HBT's, and in particular is compatible with more-recently developed HBT process flow, which will now be illustrated with reference to FIG 4. and FIG. 5. FIG. 4 shows, schematically, processing steps associated with a DSPA-SEG structure, for comparison with the BJT processing steps according to the present disclosure. Thus the corresponding processing steps for the new BJT architecture are shown in FIG. 5

Considering first the DPSA-SEG SiGe device: at FIG. 4 (i) is shown the part-processed DPSA-SEG device. The device comprises a silicon substrate 410, which typically is doped p-type, and which includes oxide regions 412 which provide deep and/or shallow trench isolation (DTI/STI) between structures. On the silicon substrate 110 is a deposited layer 414 of oxide such as TEOS oxide. This oxide layer may be referred to as a cavity oxide. A polysilicon layer 430 has been deposited over the TEOS oxide. The polysilicon layer 430 may be either in-situ p+ doped or doped p+, for instance, by means of diffusion or ion implantation. A dielectric (typically nitride) layer 432 is then deposited followed by an oxide layer deposition 434. The oxide layer 434, nitride layer 432, and the polysilicon layer 430 have had a window opened into it through a photolithography stage ("EMW' photolithography or "emitter window" photolithography) and an anisotropic etch (typically an RIE) of the oxide/nitride/polysilicon film in the window, exposing the cavity oxide 414). A dielectric spacer 438, which may typically be a nitride spacer, is then formed on the sidewalls 436 of the PSB. This is typically formed by a deposition of a further dielectric layer - typically nitride - and a subsequent RIE, (not shown in FIG. 1B). Oxide layer 434 and the cavity oxide 414 act as etch stop layers for this subsequent RIE. This further dielectric layer may be relatively thin (such as a few 10s of nm), resulting in thin "spacers" on the sidewalls of the emitter window.

At (ii) is shown the part-processed device at a subsequent stage of the processing, in which the cavity oxide exposed in the window has been wet etched, which results, as shown, in an undercut or cavity 416 in the polysilicon base 430, and an exposed surface 417 of the silicon substrate 410.

At (iii) is shown the part-processed device at a subsequent stage of the processing, in which a SiGe layer stack 418 is grown on the exposed surface 417 of the silicon 410, including in the undercut or cavity. Typically the SiGe layer stack comprises several layers of different composition and/or different doping, such as Si/SiGe/Si, or Si/SiGe/SiGe-B/Si, where SiGe-B indicates a layer which is doped p-type by Boron; the layers are grown sequentially, and the totality of the layers completely fill the undercut or cavity.

At (iv) is shown the part-processed device at a subsequent stage of the processing, in which a photoresist layer has been deposited across the entire structure. It will be appreciated that the deposited photoresist layer will protect the complete the DPSA-SEG structure from an immediately subsequent processing step (which, as will be more evident hereinbelow, comprises the ion implantation of the p-type base layer 152 of the BJT which is fabricated simultaneously with the DPSA-SEG).

Turning now to FIG. 5, this illustrates how the same processing steps described for the DPSA-SEG are used in the fabrication of the BJT according to embodiments of the present disclosure.

By comparing part-processed stage (i) of FIG. 5 with the corresponding part-processing stage (i) of FIG. 4, it can be seen that this part of the process is the same for the DPSA-SEG, and the BJT according to embodiments of the present disclosure. Similarly, by comparing part-processed stage (ii) of FIG. 5 with the corresponding part-processing stage (ii) of FIG. 4, it can be seen that this part of the process is the same for the DPSA-SEG, and the BJT according to embodiments of the present disclosure. And comparing part-processed stage (iii) of FIG. 5 with the corresponding part-processing stage (iii) of FIG. 4, it can be seen that this part of the process is the same for the DPSA-SEG, and the BJT according to embodiments of the present disclosure.

Turning now to stage (iv) in the fabrication of a BJT according to embodiments of the present disclosure, here it can be seen that the photolithography stage which produces the photoresist layer 444 across the entirety of the DPSA-SEG is used to open a window 446 in the photoresist layer 448 of the BJT. The SiGe layer stack now exposed at the bottom of the opening 240 is removed by etching. The implantation of p-doping ions into the silicon substrate 410 to form p-doped base region of the BJT is enabled through the window in the photoresist. It will be apparent to the skilled person that the photoresist protecting the entirety of the DPSA-SEG device precludes ion implantation into that device during this stage of fabrication

It can be seen from FIG. 4 and FIG. 5 that the BJT process according to embodiments of the present disclosure is compatible with DPSA-SEG fabrication processes, and requires only one additional photolithography stage (that is to say, one additional mask) to enable combined fabrication of both types of structure on the same substrate and in the same device.

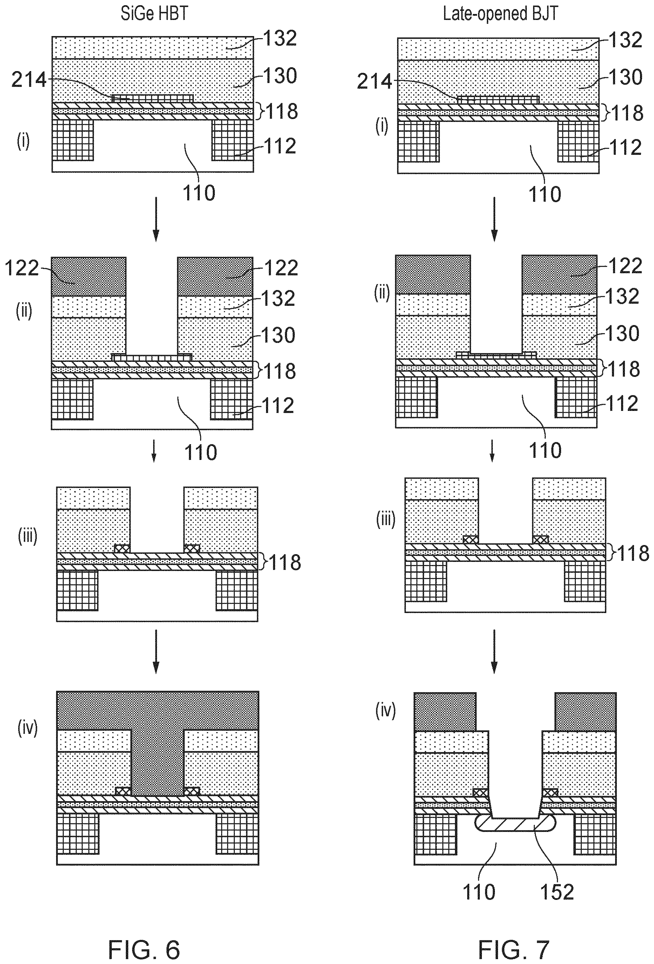

Turning now to FIG. 6 and FIG. 7, these figures show corresponding stages of part-processed devices for a conventional (that is to say, not DPSA-SEG) SiGe HBT at FIG.6, and late opened BJT according to embodiments of the present disclosure, which are fabricated at the same time on the same wafer and potentially in the same device or product.

Considering first FIG. 6, at (i) is shown the SiGe HBT after several steps in the fabrication process. Specifically is shown the silicon substrate 110, with DTI regions 112 therein. On the silicon substrate is a deposited SiGe layer stack 118. An oxide layer 214, such as TEOS oxide, and referred to as EP oxide, has been patterned to result in a layer over parts of the device, and specifically over the region in which the HBT will be fabricated: the layer is absent over other parts of the device. Polysilicon base layer 130 material has been grown or deposited over the entirety of the device, as has dielectric layer 132.

At (ii) is shown the part-processed device at a subsequent stage of the processing, in which a photolithography stage has been carried ("EMW" photolithography or emitter window photolithography) and the polysilicon base layer 130 and dielectric 132 selectively removed from the device areas absent photoresist 122, to expose the EP oxide 214, which acts as an etch stop for the etch process.

At (iii) is shown the part-processed device at a subsequent stage of the processing, in which the EP oxide layer 214 previously used as an etch stop has been removed by wet etching. This exposes the SiGe layer stack 118 through the opening. The wet etch processing removes the EP oxide which extended beyond the emitter window, resulting in an undercut or cavity beneath the polysilicon layer 130. This undercut region is subsequently filled in or "sealed" by a subsequent processing stage comprising a hydrogen-based anneal. In the H2 anneal processing step, silicon from the polysilicon base layer migrates into the cavity in order to fill in the undercut cavity.

At (iv) is shown the part-processed device at a subsequent stage of the processing, in which a photoresist layer masks the entire structure. It will be appreciated that the deposited photoresist layer, window-free over the entire HBT region, will protect the complete HBT structure from a subsequent processing step (which, as will be more evident hereinbelow, comprises the ion implantation of the p-type base layer 152 of the BJT which is fabricated simultaneously with the HBT).

Turning now to FIG. 7, this shows a part-processed BJT device according to one or more embodiments of the present disclosure, at four stages of the processing corresponding to those shown for the SiGe HBT in FIG. 6. As can be seen, the first three of the stages of processing correspond directly to that of the SiGe HBT shown in FIG. 6. Thus, at (i) the silicon substrate 110 is shown, with DTI regions 112 therein. On the silicon substrate is a deposited SiGe layer stack 118. An oxide layer (EP oxide 214) has been patterned to result in a layer over parts of the device, and specifically over the region in which the HBT will be fabricated: the layer is absent over other parts of the device. Polysilicon base layer 130 material has been grown or deposited over the entirety of the device, as has dielectric layer 132.

Similarly, at (ii) a photolithography stage has been carried out ("EMW' photolithography or emitter window photolithography) and the polysilicon base 130 and dielectric 132 selectively removed from the device areas absent photoresist 122 to expose the EP oxide 214, which acts as an etch stop to the process.

And at (iii) the EP oxide layer 214 previously used as an etch stop has been removed by wet etching. This exposes the SiGe layer stack 118 through the opening. The wet etch processing exposes a cavity or undercut region of the EP TEOS. This undercut region is subsequently filled in or sealed by a subsequent processing stage comprising a hydrogen-based anneal. In the H2 anneal processing step silicon from the polysilicon base layer migrates into the undercut cavity.

At (iv) is shown the part-processed device at a subsequent stage of the processing, in which a photoresist layer has been deposited across the part of the structure. In contrast to the stage of the processing of the SiGe HBT, in which the photoresist layer masks the entire structure, during this photolithography stage (which may also conveniently be referred to as "silicon bipolar photolithography", or SBP photolithography) a window is etched through the SiGe layer stack 118 where this is exposed by the prior etching through the polysilicon base layer 130 and dielectric 132. The base of the BJT is then created by an ion implantation stage to form the p-doped region 152 in the silicon substrate 110.

FIG. 8 shows, schematically, a BJT device manufactured according to a conventional process flow. This figure is provided for comparison with FIG. 9, which shows, schematically, a BJT device manufactured by a "late opening" process flow according to one or more embodiments of the present disclosure. Comparing FIG. 6 with the last stage of the part-processed device of the BJT manufactured according to conventional process flow in FIG.2, it will be apparent to that further processing steps have been undertaken, in particular but not limited to providing a highly doped emitter region 802 within the base region 512, (typically by overdoping a part of the base region) and providing a dielectric liner to the window through the polysilicon base layer 130. The dielectric liner is typically referred to as an emitter-base spacer 804. It may be of the same material as the nitride layer 132. Although, for the sake of clarity, the emitter-base space layer is shown as a single layer, in practical devices it may be a stack of layers, such as a thin oxide layer covered by a thicker nitride layer. A further polysilicon layer 806 has been deposited in this window, protected from the polysilicon base 130 by the emitter-base spacer 804, and providing an emitter contact region for the emitter 802. The skilled person will note that the SiGe layer stack 118 is absent from both above the emitter window and from above the entirety of the base region 512. As can be seen, there is polysilicon base 130 material between the SiGe layer stack 118 and the emitter-base spacer 804 around the inside perimeter of the emitter window. The skilled person will appreciate that the "collector" region of the BJT is formed in the silicon substrate material, under the emitter and base, at 808.

As mentioned above, FIG. 9 shows, schematically, a BJT device manufactured by a late opening process flow according to one or more embodiments of the present disclosure. Comparing this figure with the last stage shown of the part-processed figure shown in FIG. 3 stage, it is immediately apparent that later processing has included the highly doped emitter region 802, emitter-base spacer 804, and the polysilicon emitter contact region 806. However, in the cross-section through the device according to embodiments of the present disclosure as depicted in FIG.9, the SiGe layer stack 118 abuts the emitter window at its perimeter 902 and is in direct contact with the spacer material 804. This is a result of the process, in which the opening in the SiGe layer stack is made at a relatively late stage of the process flow.

From reading the present disclosure, other variations and modifications will be apparent to the skilled person. Such variations and modifications may involve equivalent and other features which are already known in the art of semiconductor device processing, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

It is noted that one or more embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Features which are described in the context of separate embodiments may also be provided in combination in a single embodiment. Conversely, various features which are, for brevity, described in the context of a single embodiment, may also be provided separately or in any suitable sub-combination.

For the sake of completeness it is also stated that the term "comprising" does not exclude other elements or steps, the term "a" or "an" does not exclude a plurality, a single processor or other unit may fulfil the functions of several means recited in the claims [delete if not relevant] and reference signs in the claims shall not be construed as limiting the scope of the claims. Furthermore, the word "may" is used in a permissive sense (i.e., meaning having the potential to), rather than the mandatory sense (i.e., meaning must). Similarly, the words "include," "including," and "includes" mean including, but not limited to.

### LIST OF SYMBOLS

- 110: Si Substrate
- 112: DTI/STI region
- 114: Pad oxide
- 116: BD Nitride
- 118: SiGe layer Stack
- 120: seed polysilicon layer
- 122: photoresist layer
- 130: polysilicon layer
- 132: dielectric layer
- 140: emitter window
- 142: partially removed silicon substrate
- 144: photoresist layer
- 152: p+ base region
- 214: em itter protect oxide
- 222: photoresist layer
- 240: opening in emitter protect oxide
- 410: silicon substrate
- 412: STI region
- 414: oxide
- 416: undercut cavity
- 417: exposed surface of silicon substrate
- 418: SiGe layer stack
- 430: polysilicon layer
- 432: dielectric layer
- 434: nitride layer
- 436: PSB sidewall
- 438: dielectric spacers
- 444: photoresist layer
- 446: window
- 448: photoresist layer
- 512: base region
- 802: emitter region
- 804: emitter-base spacer
- 806: polysilicon emitter contact
- 808: collector region
- 902: emitter window perimeter

## Claims

1. A Bipolar Junction Transistor, BJT, comprising
a silicon substrate (110) having a major surface;
a base region (512) within the silicon substrate and adjacent the major surface;
a doped emitter region (802) within the base region and adjacent the major surface;
a layer stack (118) comprising SiGe, overlaying the silicon on the major surface;
a polysilicon base layer (130) overlaying the layer stack comprising SiGe, the polysilicon base layer and the layer stack comprising SiGe having a window therethrough;
a dielectric material (804, 132), forming a dielectric spacer lining the inside perimeter of the window, and at least partially overlaying an upper surface of the base layer; and
a polysilicon emitter contact (806), at least partially filling the window within the liner and at least partially overlying the dielectric liner material on the upper surface of the polysilicon base layer, in electrical contact with the doped emitter region and isolated from the base region by the dielectric spacer;
wherein the layer stack comprising SiGe abuts the window and is in direct contact with the dielectric spacer.

2. The BJT according to claim 1, wherein the polysilicon base layer is electrically connected to the base region through the layer stack comprising SiGe.

3. The BJT according to claim 1 or 2 further wherein the layer stack comprising SiGe comprises a top layer of Si, a bottom layer of Si, and at least one layer of SiGe therebetween.

4. The BJT according to any preceding claim, wherein the window extends into the silicon substrate.

5. The BJT according to any preceding claim, wherein the dielectric spacer at least partially overlaying an upper surface of the polysilicon base layer is thicker than the dielectric spacer adjacent the layer stack comprising SiGe.

6. A semiconductor device comprising:
a SiGe Heterojunction Bipolar Transistor;
and a BJT according to any preceding claim.

7. A method of manufacturing a silicon bipolar junction transistor device, the method comprising a sequence of steps including:
prior (2010) processing steps;
depositing (2022) a polysilicon layer over at least a device region;
depositing (2023) a dielectric layer over the polysilicon layer;
patterning (2024) a photoresist layer and etching (2026) a window in the dielectric layer and the polysilicon layer through an opening in the photoresist layer;
patterning (2032) a further photoresist layer to expose at least the window;
etching (2034) a layer stack comprising SiGe through the window, to expose a silicon layer thereunder;
doping (2036) the silicon layer by ion implantation through the window to form a base region; and
subsequent (2042) processing steps.

8. The method of claim 6, further comprising, between the steps of patterning a photoresist layer and etching a window in the dielectric layer and the polysilicon layer through an opening in the photoresist layer, and etching the layer stack comprising SiGe through the window, to expose a silicon layer thereunder, the step of:
etching through a patterned oxide layer over the layer stack comprising SiGe.

9. The method of claim 6 or 7, wherein the subsequent processing steps includes:
overdoping a part of the base region to form an emitter region.

10. The method of any of claims 6 to 8, wherein:
the prior processing steps includes:
depositing a layer of oxide over at least the device region;
and further comprising,
after etching (2026) a window in the dielectric layer and the polysilicon layer through an opening in the photoresist layer:
etching (2028) through a thereby exposed region of the oxide to form a cavity, and
depositing a SiGe layer stack to fill the cavity.

11. The method of claim 9, wherein
the cavity comprises an undercut region below the polysilicon layer.

12. The method of claim10 or 11, wherein
the oxide comprises Tetra-Ethyl Ortho-Silicate, TEOS, oxide.

13. The method of any of claims 6 to 11, wherein the layer stack comprising SiGe, comprises a Si/SiGe/Si stack.

14. The method of any of claims 6 to 12, wherein etching a layer stack comprising SiGe through the window is performed using an anisotropic etching process.

15. The method of any of claims 6 to 13, further comprising, after the step of etching (2026) a window in the dielectric layer and the polysilicon layer through an opening in the photoresist layer, depositing a further dielectric layer and etching an opening in the further dielectric layer in the bottom of the window.

## Amended claims

### Amended claims in accordance with Rule 137(2) EPC.

1. A silicon Bipolar Junction Transistor, BJT, comprising
a silicon substrate (110) having a major surface;
a base region (512) within the silicon substrate and adjacent the major surface; a doped emitter region (802) within the base region and adjacent the major surface;
a layer stack (118) comprising SiGe, overlaying the silicon on the major surface;
a polysilicon base layer (130) overlaying the layer stack comprising SiGe, the polysilicon base layer and the layer stack comprising SiGe having a window therethrough, wherein the polysilicon base layer is electrically connected to the base region through the layer stack comprising SiGe, and wherein the layer stack comprising SiGe comprises a top layer of Si, a bottom layer of Si, and at least one layer of SiGe therebetween;
a dielectric material (804, 132), forming a dielectric spacer lining the inside perimeter of the window, and at least partially overlaying an upper surface of the base layer; and
a polysilicon emitter contact (806), at least partially filling the window within the liner and at least partially overlying the dielectric liner material on the upper surface of the polysilicon base layer, in electrical contact with the doped emitter region and isolated from the base region by the dielectric spacer;
wherein the layer stack comprising SiGe abuts the window and is in direct contact with the dielectric spacer.

2. The silicon BJT according to claim 1, wherein the window extends into the silicon substrate.

3. The silicon BJT according to any preceding claim, wherein the dielectric spacer at least partially overlaying an upper surface of the polysilicon base layer is thicker than the dielectric spacer adjacent the layer stack comprising SiGe.

4. A semiconductor device comprising:
a SiGe Heterojunction Bipolar Transistor;
and a silicon BJT according to any preceding claim.

5. A method of manufacturing a silicon bipolar junction transistor device, the method comprising a sequence of steps including:
prior (2010) processing steps;
depositing (2022) a polysilicon layer over at least a device region;
depositing (2023) a dielectric layer over the polysilicon layer;
patterning (2024) a photoresist layer and etching (2026) a window in the dielectric layer and the polysilicon layer through an opening in the photoresist layer;
patterning (2032) a further photoresist layer to expose at least the window;
etching (2034) a layer stack comprising SiGe through the window, to expose a silicon layer thereunder;
doping (2036) the silicon layer by ion implantation through the window to form a base region; and
subsequent (2042) processing steps.

6. The method of claim 5, further comprising, between the steps of patterning a photoresist layer and etching a window in the dielectric layer and the polysilicon layer through an opening in the photoresist layer, and etching the layer stack comprising SiGe through the window, to expose a silicon layer thereunder, the step of:
etching through a patterned oxide layer over the layer stack comprising SiGe.

7. The method of claim 5 or 6, wherein the subsequent processing steps includes:
overdoping a part of the base region to form an emitter region.

8. The method of any of claims 5 to 7, wherein:
the prior processing steps includes:
depositing a layer of oxide over at least the device region;
and further comprising,
after etching (2026) a window in the dielectric layer and the polysilicon layer through an opening in the photoresist layer:
etching (2028) through a thereby exposed region of the oxide to form a cavity, and
depositing a SiGe layer stack to fill the cavity.

9. The method of claim 8, wherein
the cavity comprises an undercut region below the polysilicon layer.

10. The method of claim 8 or 9, wherein
the oxide comprises Tetra-Ethyl Ortho-Silicate, TEOS, oxide.

11. The method of any of claims 5 to 10, wherein the layer stack comprising SiGe, comprises a Si/SiGe/Si stack.

12. The method of any of claims 5 to 11, wherein etching a layer stack comprising SiGe through the window is performed using an anisotropic etching process.

13. The method of any of claims 5 to 12, further comprising, after the step of etching (2026) a window in the dielectric layer and the polysilicon layer through an opening in the photoresist layer, depositing a further dielectric layer and etching an opening in the further dielectric layer in the bottom of the window.
